# EUROPEAN PATENT SPECIFICATION

(11) **EP 0 434 182 B1**
(45) Date of publication and mention of the grant of the patent: **03.04.2002**
(21) Application number: 90308305.3
(22) Date of filing: 27.07.1990
(51) Int. Cl.: H01L 21/74, H01L 21/266

(54) **Fabrication of buried layers in integrated circuits**
Verfahren zur Herstellung vergrabener Zonen für integrierte Schaltungen
Procédé de fabrication de couches enterrées pour circuits intégrés

(30) Priority: 22.12.1989 US 455696
(43) Date of publication of application: 26.06.1991
(73) Proprietor: SAMSUNG SEMICONDUCTOR, INC., San Jose, California 95134-1708 (US)
(72) Inventor: Zekeriya, Viktor, Menlo Park, California 94025 (US); Cheruvu, S. Murty, Cupertino, California 95014 (US)
(74) Representative: Jones, Ian

(56) References cited:
- EP-A- 0 276 571
- US-A- 4 282 648
- US-A- 4 574 469
- US-A- 4 641 419
- US-A- 4 840 920
- Silicon Processing for the VLSI Era, Volume 1- Process Technology, S. Wolf, R.N. Tauber, Lattice Press 1986, page 534

## Description

This invention relates to the fabrication of buried layers in integrated circuits, for example, to forming buried layers with low capacitive coupling in such devices as bipolar, CMOS and BiCMOS devices.

Buried layers provide junction isolation in bipolar and MOSFET integrated circuits. The uses for buried layers include forming the sub-collector of NPN transistors in bipolar and BiCMOS processes, and forming isolated P-wells and N-wells in CMOS and BiCMOS processes. In bipolar devices, and especially NPN transistors, the capacitance of the collector-substrate junction affects the speed of the device, and must be a low value if device speed is important. In BiCMOS devices, the well to well capacitance affects noise and signal coupling, and must be a low value if noise and coupling problems are to be avoided.

In the process disclosed in United States Patent Number 4,381,956, issued May 3, 1983 to Lane, adjacent buried channels of different conductivity type are formed as follows. A P-type substrate is covered by a first mask that is impervious or resistant to oxidation and the selected N-type impurity. The mask has two layers, a silicon dioxide layer formed on the substrate, and a silicon nitride layer overlaying the oxide layer. The N-type dopant is implanted into selected regions of the substrate through openings in the mask. In a subsequent thermal step, the dopant is driven into the substrate under the openings, and a thick oxide forms in the openings. The thick oxide regions form a second "complementary" mask which is automatically aligned and coincident with the openings of the first mask without any additional alignment steps. The nitride layer is removed and a P-type dopant is implanted into the substrate. The thick oxide regions protect the previously implanted N-type regions from the P-type implant. Unfortunately, the resulting N-type and P-type buried channels are not well "separated" from one another, meaning that the carrier concentration of both dopants in the junction region at the end of the process is relatively high. As a result, significant capacitive coupling is present between the buried layers, for reasons more fully described in R. S. Miller and T. I. Kamins, "Device Electronics for Integrated Circuits, "J. Wiley & Sons, Inc., 1977, P. 125.

US-A-4 840 920 also discloses a method in which an oxide-nitride mask is used to define buried layer spacings.

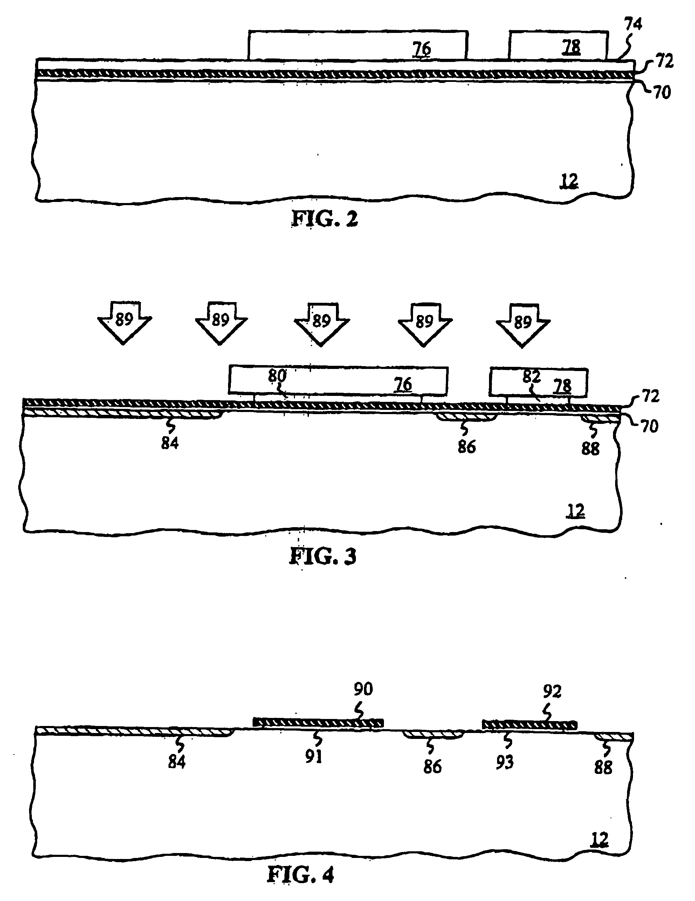

A technique for providing self-alignment of buried layer regions to achieve controlled lateral separation of buried layer regions and channel stop regions is disclosed in United States Patent Number 4,574,469, issued March 11, 1986 to Mastroianni et al. As will be seen by reference to Figure 2K of Mastroianni et al., a separation 21d between the buried layers and the channel stops is achieved. According to Mastroianni et al., the separation 21d can be controlled by varying the widths of certain mask openings while taking into account the lateral spreading of the doped regions during the thermal process steps. Two masks are needed to achieve this result. With reference to Figure 2A of Mastroianni et al., the first mask is used to form openings and a spacing element in a oxide-nitride double masking layer. The spacing element determines the separation of the buried layer regions to be formed in the substrate. It will be appreciated that the minimum width of the spacing element is limited by the resolution of the photolithographic equipment used. With reference to Figure 2B of Mastroianni et al., the second mask is used to shield certain substrate regions from an N-type buried layer implant while opening other substrate regions to the implant.

EP-A-0 276 571 employs a nitride-photoresist structure on a thermal oxide layer to define buried layer spacings.

In Silicon Processing for the ULSI Era, Vol. 1 - Process Technology, S.Wolf, R.N. Tauber, Lattice Press, 1986, page 534 it is proposed to use an oxide layer patterned using a photoresist mask to mask a nitride layer during patterning using wet-etching.

According to the present invention there is provided a method of fabricating laterally separated buried layers in an integrated circuit, as defined in claim 1.

The present invention achieves a controlled lateral separation between buried layers for various types of integrated circuits, including bipolar, CMOS and BiCMOS integrated circuits, by the use of only a single mask. The controlled separation feature promotes reduced collector-substrate capacitance and well-to-well junction capacitance. The use of only a single ion implant mask step results in a more economical process.

These and other advantages are achieved by the present invention, a method for fabricating separated buried layers in an integrated circuit. A structure which includes oxide-nitride-oxide layers in the preferred embodiment, is formed over a substrate. A further layer, which in the preferred embodiment is a photoresist, is formed over said structure. The further layer is patterned in accordance with a first dopant type buried layer ion implant mask; first masking features result. Using these first masking features, further masking features are formed from said structure). These further masking features, which in the preferred embodiment are formed in an oxide-nitride layer, are self-aligned with and have a selected undercut with respect to the first masking features. A dopant of a first type is implanted into regions of the substrate other than those overlaid by said first masking features. Final masking features are formed over regions of the substrate other than the regions overlaid by the further masking features. Then, a dopant of a second type is implanted into regions of the substrate other than those overlaid by the final masking features. Finally, an epitaxial silicon layer is grown over the substrate.

The invention is further described below, by way of example, with reference to the accompanying drawings, in which:
FIGURE 1 is a cross section of a substantially completed integrated circuit which may be manufactured using the method of the present invention;
FIGURES 2-7 are cross section illustrations showing intermediate steps in the fabrication of the integrated circuit of Figure 1; and
FIGURES 8 and 9 are graphs illustrating profiles for the N+ and P+ buried layers of Figure 1.

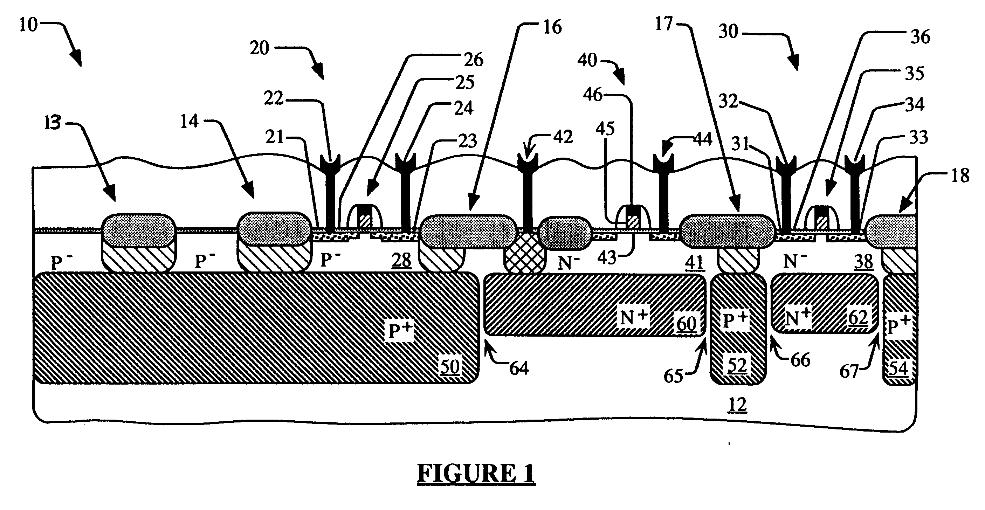

A cross section of a twin buried layer BiCMOS integrated circuit 10 having a reduced collector-to-substrate capacitance is shown in Figure 1. The integrated circuit 10 comprises NMOS transistor 20 fabricated in P-well 28, PMOS transistor 30 fabricated in N-well 38, and vertical NPN transistor 40. These transistors are isolated from one another and from other regions of the integrated circuit by various isolation structures 13, 14, 16, 17, and 18, each of which includes a field oxide region and a P+ field implant extending down to a P+ buried layer. The NMOS transistor 20 includes source 21 and drain 23 of the LDD type, source and drain contacts 22 and 24, and a gate structure 25 which includes a metal contact overlaying a polysilicon gate, bounded by sidewall spacers and insulated from the channel region by gate oxide 26. The PMOS transistor 30 includes source 31 and drain 33, source and drain contacts 32 and 34, and a gate structure 35 which includes a metal contact overlaying a polysilicon gate, bounded by sidewall spacers and insulated from the channel region by gate oxide 36. The NPN transistor 40 includes N-well 41 which functions as a collector, base 43, and emitter 45. A contact structure 42, which includes an aluminum contact overlaying and making ohmic contact with a N+ doped collector sink in the N-well 41, is provided for contact to the collector 41. A contact structure 44 including an aluminum contact overlaying and making ohmic contact with a P-type doped region above the N-well 41 is provided for contact to the base 43. A silicide conductor 46 which contacts first metal (not shown) is provided for contact to the emitter 45. These structures and processes suitable for fabricating them are readily available and well known in the art.

Figure 1 also shows P+ buried layers 50, 52 and 54, and N+ buried layers 60 and 62 in substrate 12. The various buried layers are separated from neighboring buried layers in a controlled manner, as explained in detail below, which minimizes the capacitance between the collector 41 and the substrate 12 (through reduction of the capacitance between the N+ and P+ buried layers) and improves the switching speed of the transistor 40; and also reduces the well-to-well capacitance of the MOS transistors 20 and 30, which minimizes noise and signal coupling.

The formation of buried layers 50, 52, 54, 60 and 62 is illustrated in Figures 2-7.

As shown in Figure 2, a stress relief oxide 70 is grown on the starting material, a typical N or P- type wafer, using conventional thermal techniques to a thickness in the 100-1000 Å range. For example, a thickness of 380 Å is suitable. Next, a nitride layer 72 is formed using conventional low pressure chemical vapor deposition ("LPCVD") techniques to a thickness in the range of a few hundred Angstroms to several thousand Angstroms. For example, a thickness of 1500 Å is suitable. The wafer is scribed, followed by the deposition of an oxide using conventional CVD techniques (high or low temperature) to a suitable thickness, as described below.

Next, a P+ buried layer mask is applied for selectively defining the substrate regions to receive the P+ buried layer implant. The masking technique is conventional, involving the deposition of a suitable positive photoresist of sufficient thickness to prevent subsequently implanted boron ions from reaching the substrate 12. In accordance with practices well understood in the art, the photoresist is deposited to a thickness in the range of about 0.5 micrometers to 2 micrometers; e.g. 1.1 micrometers is suitable. As the process is tolerant of wide variation in photoresist thickness, the selected thickness within this range depends on considerations other than those relating to formation of the buried layers 50, 52, 54, 60 and 62. The photoresist layer is suitably imaged and etched to form ion implant stop masking features 76 and 78.

As shown in Figure 3, the oxide layer 74 is patterned using the ion implant stop masking features 76 and 78 as a mask to form oxide masking features 80 and 82. The underlying nitride layer 72 functions as an etch stop layer. As is apparent below, the degree by which the implant stop masking features 76 and 78 are undercut is important in establishing the controlled lateral separation of the buried layers 50, 60, 52, 62 and 54. The degree of undercut is dependent on several factors, including the thickness of the oxide layer 74, the type and concentration of the oxide isotropic etchant used, and the etch time and temperature. For an oxide layer 74 having a thickness of about 2000 Å +/- 200 Å, immersion in an HF based etchant in a 7:1 solution for about two minutes at a temperature of 25 °C achieves a suitable undercut of about 0.5 micrometers. Note that although the thickness of the oxide layer generally is maintained within 10 percent, in fact a greater but still moderate perturbation will have little effect. This is because the variation in thickness of the oxide layer 74 is smaller than the extent of undercut; compare 0.02 micrometers with 0.5 micrometers. If desired, the well known technique of critical dimension testing may be used to ensure that process parameters are within tolerance.

Following the oxide etch, a suitable P+ buried layer implant (arrows 89) is made. Values for the implant parameters are selected to achieve a desired dopant concentration in the regions 84, 86, and 88, based on the type and thickness of the layers overlaying these regions and the final profile desired for buried layers 50, 52 and 54. For example, suitable values for a boron implant through layers 72 and 70 include doses in the range of 1x10¹³ to 4x10¹³ and voltages in the range of 50-150 keV.

As shown in Figure 4, the implant stop masking features 76 and 78 are removed in a suitable resist strip, and the nitride layer 72 (Figure 3) is patterned using the oxide features 80 and 82 as a mask to form nitride masking features 90 and 92. The nitride layer 72 is etched using a dry etch technique, as is well known in the art. The oxide layer 70 (Figure 3) then is removed in a suitable wet etch, e.g. a 10:1 or 7:1 HF solution, resulting in base oxide sections 91 and 93 underlying nitride masking features 90 and 92. The oxide masking features 80 and 82 may or may not be entirely removed, as desired. Since the oxide layer 70 is overetched to ensure complete removal except under nitride masking features 90 and 92, some undercutting of the nitride masking features 90 and 92 occurs. Depending on whether a short or long overetch is used, the undercutting varies from about 0.05 um to 0.10 um. The effect of the undercut is to somewhat increase a subsequently formed bird's beak, as discussed below. Note that if base oxide layer 70 and oxide layer 74 are desired to be of different thickness than set forth herein, the feature size in the buried layer mask forming implant stop masking features 76 and 78 should be adjusted accordingly.

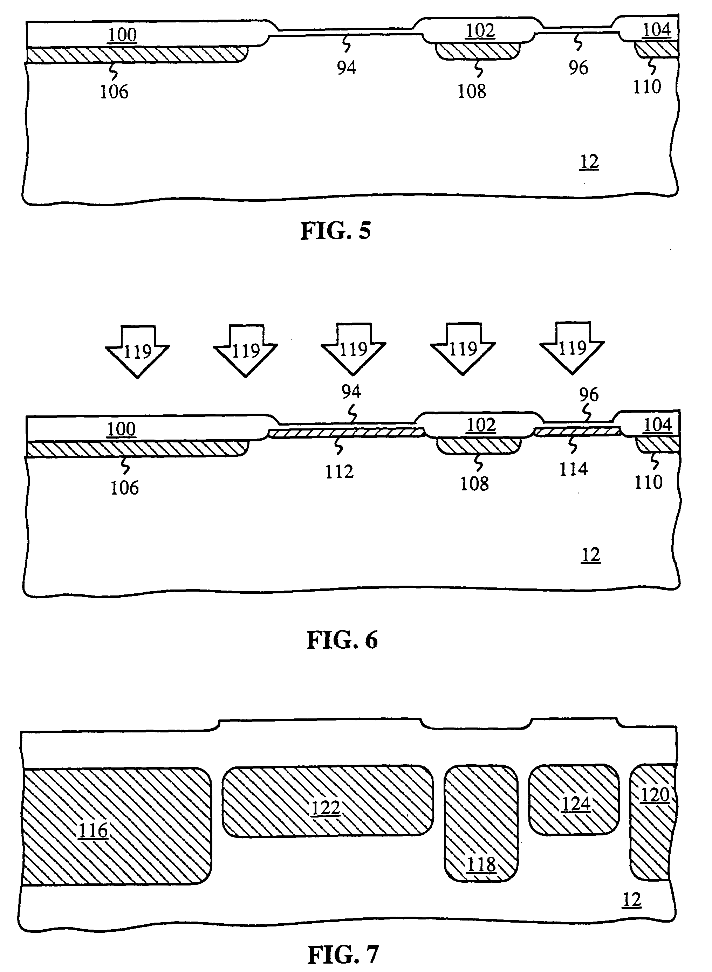

Next, as shown in Figure 5, a conventional thermal oxidation step is performed to grow thick thermal oxide masking features 100, 102 and 104 of sufficient thickness to prevent subsequently implanted arsenic ions from reaching the substrate 12. In accordance with practices well understood in the art, the oxide is grown to a thickness in the range of about 2000 Å to 5000 Å at a temperature of from 900-1000 °C. As the process is tolerant of wide variation in oxide thickness, the selected thickness within this range depends on considerations other than those relating to formation of the buried layers 50, 52, 54, 60 and 62. Oxide masking features 100, 102, and 104 form in areas over which nitride masking features 90 and 92 (Figure 4) are absent. Nitride masking features 90 and 92 inhibit oxide growth in the substrate regions which they overlay. Note that bird's beaks form at the edges of the nitride-oxide features 90, 91 and 92, 93, and have the effect of increasing the edge dislocation with respect to the ion implant stop mask features 76 and 78 by about 0.15 - 0.3 micrometers (this number is mostly dependent on the thermal oxide thickness, and somewhat dependent on other factors such as the extent of the overetch of layer 70), resulting in an effective edge dislocation in the range of 0.65 - 0.8 micrometers.

While the implant regions 84, 86 and 88 are somewhat annealed and driven in during the thermal oxidation to form dopant regions 106, 108, 110, a subsequent anneal and drive-in (discussed below) is necessary.

Nitride masking features 90 and 92, and oxide features 91 and 93 are stripped using suitable techniques, and an implant oxide is thermally grown to a thickness of 150 Å, forming features 94 and 96.

Next, as illustrated in Figure 6, an N+ buried layer implant (arrows 119) is made. Values for the implant parameters are selected to achieve a desired dopant concentration in the regions 112 and 114, based on the type and thickness of the layers overlaying these regions and the final profile desired for buried layers 50, 52 and 54. For example, suitable values for an arsenic implant through features 94 and 96 include doses in the range of 3 x 10¹⁵ to 8 x 10¹⁵ and voltages in the range of 40-80 keV. This implant results in N+ regions 112 and 114 that are self aligned with and separated from, respectively, regions 106 and 108, and regions 108 and 110.

Next, the P+ and N+ implants are annealed and driven in at a temperature in the range of 1000-1100 °C for 1-3 hours to form the P+ regions 116, 118 and 120, and the N+ regions 122 and 124, as shown in Figure 7. Using well known techniques, the oxide masking features 94, 96, 100, 102 and 104 are stripped, the surface of substrate 12 is cleaned, and an epitaxial silicon layer of about 1.5 micrometer thickness and having a resistivity of from 5 ohms-cm to 21 ohms-cm is grown.

Subsequently, MOS devices, bipolar devices, BiCMOS devices, or other such devices are fabricated using techniques well known in the art to achieve an integrated circuit 10 such as shown in Figure 1. The subsequent fabrication steps generally are performed at lower temperatures than the various implant anneals, so that relatively little migration of the implanted impurities in regions 116, 118, 120, 122 and 124 occurs. Buried layers 50, 52, 54, 60 and 62 result.

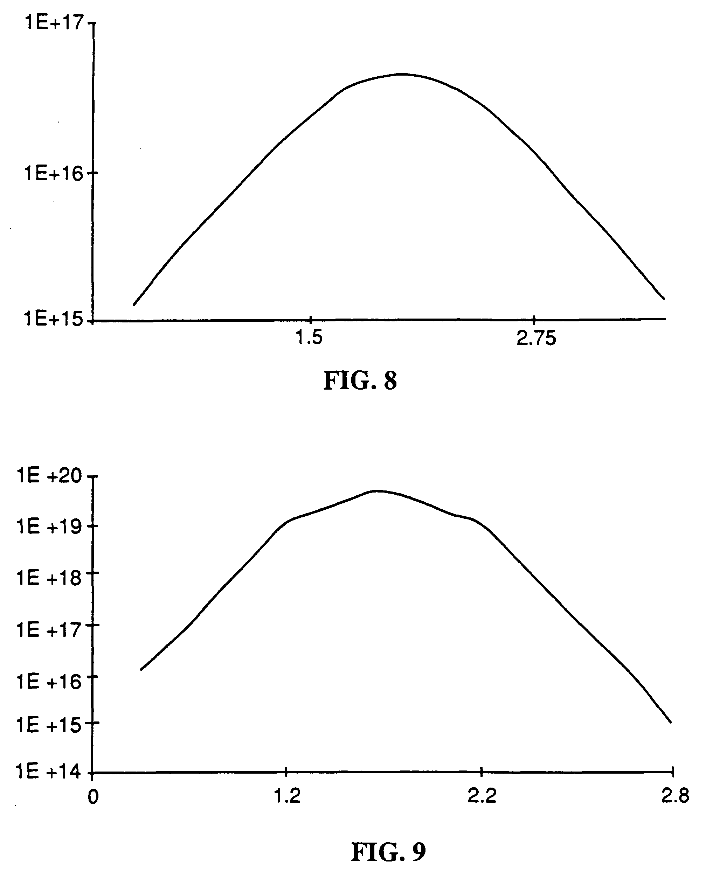

The buried layers 50, 52, 54, 60 and 62 of Figure 1 have the following characteristics. The average boron concentration in regions 50, 52 and 54 is in the range of 1 x 10¹⁶ - 1 x 10¹⁷. The average arsenic concentration in regions 60 and 62 is in the range 1 x 10¹⁹ - 1 x 10²⁰. A suitable P+ buried layer profile corresponding to buried layers 50, 52, and 54 is shown in Figure 8; and a suitable N+ buried layer profile corresponding to buried layers 60 and 62 is shown in Figure 9. In Figure 8 and 9, the vertical axes represent doping concentration and the horizontal axes represent distance from the silicon surface, in micrometers. The tails of the profiles of Figure 8 and 9 are shown without the effect of other implants, such as the field and well implants. These profiles taken with the effective edge dislocation of oxide masking features 100, 102 and 104 as discussed above uniquely determine the junctions 64, 65, 66 and 67 between the P+ and N+ buried layers. These profiles are achieved by the values selected for the P+ and N+ implant anneal and drive-in (Figure 7) temperature and time, as well for the other thermal cycles involved in fabricating the integrated circuit. All thermal cycles should be considered, as would be apparent to one of ordinary skill in the art, in selecting the values for the P+ and N+ anneal and drive-in parameters.

While my invention has been described with respect to the embodiment set forth above, other embodiments and variations not described herein are within the scope of my invention. For example, my invention should not be limited by the type of devices formed over the buried layers 50, 52, 54, 60, and 62, the dopants and doses, the sequence of dopant implants, the values of implant parameters, the values of anneal parameters, or the thicknesses of layers as set forth herein, all of which are intended to be illustrative. Other embodiments and variations not described herein are to be considered within the scope of my invention, as defined by the following claims.

## Claims

1. A method of fabricating laterally separated buried layers (116, 118, 120, 122, 124) in an integrated circuit, comprising the steps of:
forming a first layer (70) of oxide over a silicon substrate (12);
forming a second layer (72) of nitride on the first layer (70);
forming a third layer (74) on the second layer (72);
forming a fourth layer on the third layer (74);
forming first masking features (76, 78) from the fourth layer,
forming second masking features (80, 82) from the third layer (74), the second masking features (80, 82) being aligned with and having a first selected undercut with respect to the first masking features (76, 78);
implanting a dopant (89) of a first conductivity type into regions (84, 86, 88) of the substrate other than those overlaid by the first masking features (76, 78);
removing the first masking features (76, 78);
forming third masking features (90, 92) from the second layer (72), the third masking features being aligned with the second masking features (80, 82);
overetching the first layer using the third masking features as a mask to form fourth masking features (91, 93) from the first layer, the fourth masking features (91, 93) being aligned with and having a second selected undercut with respect to the third masking features (90, 92);
growing thermal oxide from the substrate (12) to form fifth masking features (100, 102, 104) over regions of the substrate (12) other than the regions overlaid by the third masking features (90, 92);
subsequent to removal of the second and third masking features implanting a dopant (119) of a second conductivity type into regions of the substrate other than those overlaid by the fifth masking features (100, 102, 104);
removing the thermal oxide on the substrate (12); and
forming an epitaxial silicon layer over the substrate (12).

2. A method as claimed in Claim 1, wherein the step of forming the second masking features (80, 82) comprises the step of isotropically etching the third layer (74) with an etchant that is comparatively nonreactive with the material of the first masking features (76, 78) and the material of the second layer (72).

3. A method as claimed in Claim 1, wherein the fourth layer is a photoresist layer.

4. A method as claimed in Claim 3, wherein the step of forming the third layer (74) comprises forming a second oxide layer (74) on the nitride layer (72), the photoresist layer being on the second oxide layer (74), and the step of forming the third and fourth masking features (90, 91, 92, 93) comprises isotropically etching the second oxide layer (74) having thereupon the first masking features (76, 78) with an etchant that is reactive with oxide and comparatively less reactive with nitride and photoresist to form the second masking features (80, 82) on the nitride layer (72), and etching the nitride layer (72) having thereupon the second masking features (80, 82) to form the third masking features (90, 92) on the first oxide layer (70).

5. A method as claimed in Claim 1, wherein the step of forming the second masking features (80, 82) comprises isotropically etching the third layer (74) with an etchant that is comparatively nonreactive with the material of the fourth layer and the material of the second layer (72) to form from the third layer (74) the second masking features (80, 82);
the step of forming the third masking features (90, 92) comprises etching the second layer (72) having thereon the second masking features (80, 82) with an etchant that is comparatively nonreactive with the material of the third layer (74) to form from the second layer (72) the third masking features (90, 92); and
the step of forming the fourth masking features (91, 93) comprises etching the first layer (70) with an etchant that is comparatively nonreactive with the material of the second layer (72) to form from the first layer (70) the fourth masking features (91, 93).

6. A method as claimed in Claim 1, wherein:
the third layer (70) is oxide; and
the fourth layer is photoresist.

## Patentansprüche

1. Verfahren zur Herstellung lateral getrennter vergrabener Schichten (116, 118, 120, 122, 124) in einer integrierten Schaltung, umfassend die folgenden Schritte:
Bilden einer ersten Schicht (70) aus Oxid über einem Siliziumsubstrat (12);
Bilden einer zweiten Schicht (72) aus Nitrid auf der ersten Schicht (70);
Bilden einer dritten Schicht (74) auf der zweiten Schicht (72);
Bilden einer vierten Schicht auf der dritten Schicht (74);
Bilden erster Maskierungsmerkmale (76, 78) von der vierten Schicht;
Bilden zweiter Maskierungsmerkmale (80, 82) von der dritten Schicht (74), wobei die zweiten Maskierungsmerkmale (80, 82) auf die ersten Maskierungsmerkmale (76, 78) ausgerichtet sind und eine erste gewählte Unterätzung in Bezug auf diese haben;
Implantieren eines Dotierungsmittels (89) eines ersten Leitfähigkeitstyps in andere Zonen (84, 86, 88) des Substrats als die, über denen die ersten Maskierungsmerkmale (76, 78) liegen;
Entfernen der ersten Maskierungsmerkmale (76, 78);
Bilden dritter Maskierungsmerkmale (90, 92) von der zweiten Schicht (72), wobei die dritten Maskierungsmerkmale auf die zweiten Maskierungsmerkmale (80, 82) ausgerichtet sind;
Überätzen der ersten Schicht mit den dritten Maskierungsmerkmalen als Maske zum Bilden vierter Maskierungsmerkmale (91, 93) von der ersten Schicht, wobei die vierten Maskierungsmerkmale (91, 93) auf die dritten Maskierungsmerkmale (90, 92) ausgerichtet sind und eine zweite gewählte Unterätzung in Bezug auf diese haben;
Aufwachsenlassen von thermischem Oxid von dem Substrat (12) zum Bilden fünfter Maskierungsmerkmale (100, 102, 104) über anderen Zonen des Substrats (12) als den Zonen, über denen die dritten Maskierungsmerkmale (90, 92) liegen;
nach dem Entfernen der zweiten und dritten Maskierungsmerkmale Implantieren eines Dotierungsmittels (119) eines zweiten Leitfähigkeitstyps in andere Zonen des Substrats als die, über denen die fünften Maskierungsmerkmale (100, 102, 104) liegen;
Entfernen des thermischen Oxids auf dem Substrat (12); und
Bilden einer Epitaxialsiliziumschicht über dem Substrat (12).

2. Verfahren nach Anspruch 1, bei dem der Schritt des Bildens der zweiten Maskierungsmerkmale (80, 82) den Schritt des isotropen Ätzens der dritten Schicht (74) mit einem Ätzmittel umfasst, das mit dem Material der ersten Maskierungsmerkmale (76, 78) und mit dem Material der zweiten Schicht (72) vergleichsweise nichtreaktiv ist.

3. Verfahren nach Anspruch 1, bei dem die vierte Schicht eine Fotoresistschicht ist.

4. Verfahren nach Anspruch 3, bei dem der Schritt des Bildens der dritten Schicht (74) das Bilden einer zweiten Oxidschicht (74) auf der Nitridschicht (72) umfasst, wobei die Fotoresistschicht auf der zweiten Oxidschicht (74) liegt, und der Schritt des Bildens der dritten und der vierten Maskierungsmerkmale (90, 91, 92, 93) das isotrope Ätzen der zweiten Oxidschicht (74) mit den ersten Maskierungsmerkmalen (76, 78) darauf mit einem Ätzmittel umfasst, das mit Oxid reaktiv und mit Nitrid und Fotoresist zur Bildung der zweiten Maskierungsmerkmale (80, 82) auf der Nitridschicht (72) vergleichsweise weniger reaktiv ist, und Ätzen der Nitridschicht (72) mit den zweiten Maskierungsmerkmalen (80, 82) darauf zum Bilden der dritten Maskierungsmerkmale (90, 92) auf der ersten Oxidschicht (70).

5. Verfahren nach Anspruch 1, bei dem der Schritt des Bildens der zweiten Maskierungsmerkmale (80, 82) das isotrope Ätzen der dritten Schicht (74) mit einem Ätzmittel umfasst, dass mit dem Material der vierten Schicht und dem Material der zweiten Schicht (72) vergleichsweise nichtreaktiv ist, um von der dritten Schicht (74) die zweiten Maskierungsmerkmale (80, 82) zu bilden;
der Schritt des Bildens der dritten Maskierungsmerkmale (90, 92) das Ätzen der zweiten Schicht (72) mit den zweiten Maskierungsmerkmalen (80, 82) darauf mit einem Ätzmittel umfasst, das mit dem Material der dritten Schicht (74) vergleichsweise nichtreaktiv ist, um von der zweiten Schicht (72) die dritten Maskierungsmerkmale (90, 92) zu bilden; und
der Schritt des Bildens der vierten Maskierungsmerkmale (91, 93) das Ätzen der ersten Schicht (70) mit einem Ätzmittel umfasst, das mit dem Material der zweiten Schicht (72) vergleichsweise nichtreaktiv ist, um von der ersten Schicht (70) die vierten Maskierungsmerkmale (91, 93) zu bilden.

6. Verfahren nach Anspruch 1, bei dem die dritte Schicht (70) Oxid und die vierte Schicht Fotoresist ist.

## Revendications

1. Procédé de fabrication de couches enterrées séparées latéralement (116, 118, 120, 122, 124) dans un circuit intégré, comprenant les étapes de :
formation d'une première couche (70) d'oxyde par-dessus un substrat de silicium (12);
formation d'une deuxième couche (72) de nitrure sur la première couche (70);
formation d'une troisième couche (74) sur la deuxième couche (72);
formation d'une quatrième couche sur la troisième couche (74);
formation de premiers détails de masquage (76, 78) à partir de la quatrième couche;
formation de deuxièmes détails de masquage (80, 82) à partir de la troisième couche (74), les deuxièmes détails de masquage (80, 82) étant alignés avec les et présentant une première attaque latérale sélectionnée par rapport aux premiers détails de masquage (76, 78);
implantation d'une impureté (89) d'un premier type de conductivité dans des zones (84, 86, 88) du substrat autres que celles recouvertes par les premiers détails de masquage (76, 78);
élimination des premiers détails de masquage (76, 78);
formation de troisièmes détails de masquage (90, 92) à partir de la deuxième couche (72), les troisièmes détails de masquage étant alignés avec les deuxièmes détails de masquage (80, 82);
surgravure de la première couche en utilisant les troisièmes détails de masquage comme masque afin de former des quatrièmes détails de masquage (91, 93) à partir de la première couche, les quatrièmes détails de masquage (91, 93) étant alignés avec et présentant une deuxième attaque latérale sélectionnée par rapport aux troisièmes détails de masquage (90, 92);
tirage d'oxyde thermique à partir du substrat (12) en vue de former des cinquièmes détails de masquage (100, 102, 104) par-dessus des zones du substrat (12) autres que les zones recouvertes par les troisièmes détails de masquage (90, 92);
après l'élimination des deuxièmes et troisièmes détails de masquage, implantation d'une impureté (119) d'un deuxième type de conductivité dans des zones du substrat autres que celles recouvertes par les cinquièmes détails de masquage (100, 102, 104);
élimination de l'oxyde thermique sur le substrat (12); et
formation d'une couche de silicium épitaxiale par-dessus le substrat (12).

2. Procédé selon la revendication 1, dans lequel l'étape de formation des deuxièmes détails de masquage (80, 82) comprend l'étape de gravure isotrope de la troisième couche (74) avec un agent de gravure qui est comparativement non réactif avec la matière des premiers détails de masquage (76, 78) et la matière de la deuxième couche (72).

3. Procédé selon la revendication 1, dans lequel la quatrième couche est une couche de photorésist.

4. Procédé selon la revendication 3, dans lequel l'étape de formation de la troisième couche (74) comprend la formation d'une deuxième couche d'oxyde (74) sur la couche de nitrure (72), la couche de photorésist étant sur la deuxième couche d'oxyde (74), et l'étape de formation des troisièmes et quatrièmes détails de masquage (90, 91, 92, 93) comprend la gravure isotrope de la deuxième couche d'oxyde (74) ayant par-dessus elle les premiers détails de masquage (76, 78) avec un agent de gravure qui est réactif avec l'oxyde et comparativement moins réactif avec le nitrure et le photorésist afin de former les deuxièmes détails de masquage (80, 82) sur la couche de nitrure (72), et la gravure de la couche de nitrure (72) ayant par-dessus elle les deuxièmes détails de masquage (80, 82) afin de former les troisièmes détails de masquage (90, 92) sur la première couche d'oxyde (70).

5. Procédé selon la revendication 1, dans lequel l'étape de formation des deuxièmes détails de masquage (80, 82) comprend la gravure isotrope de la troisième couche (74) avec un agent de gravure qui est comparativement non réactif avec la matière de la quatrième couche et la matière de la deuxième couche (72) afin de former à partir de la troisième couche (74) les deuxièmes détails de masquage (80, 82);
l'étape de formation des troisièmes détails de masquage (90, 92) comprend la gravure de la deuxième couche (72) ayant sur elle les deuxième détails de masquage (80, 82) avec un agent de gravure qui est comparativement non réactif avec la matière de la troisième couche (74) afin de former à partir de la deuxième couche (72) les troisièmes détails de masquage (90, 92); et
l'étape de formation des quatrièmes détails de masquage (91, 93) comprend la gravure de la première couche (70) avec un agent de gravure qui est comparativement non réactif avec la matière de la deuxième couche (72) afin de former à partir de la première couche (70) les quatrièmes détails de masquage (91, 93).

6. Procédé selon la revendication 1, dans lequel :
la troisième couche (70) est de l'oxyde; et
la quatrième couche est le photorésist.
